# EUROPEAN PATENT SPECIFICATION

(11) **EP 0 585 491 B1**
(45) Date of publication and mention of the grant of the patent: **25.03.1998**
(21) Application number: 92121192.6
(22) Date of filing: 11.12.1992
(51) Int. Cl.: H01L 27/06

(54) **Field of electric transistor of metal-oxide-semiconductor (MOSFET)**
Feldeffekttransistor vom Metall-Oxyd-Halbleitertyp (MOSFET)
Transistor à effet de champ de type métal-oxyde-semiconducteur (MOSFET)

(30) Priority: 01.09.1992 JP 257253/92
(43) Date of publication of application: 09.03.1994
(73) Proprietor: YOZAN INC., Tokyo 155 (JP); SHARP KABUSHIKI KAISHA, Osaka 545 (JP)
(72) Inventor: Shu, Guoliang, Setagaya-ku, Tokyo 155 (JP); Yang, Weikang, Setagaya-ku, Tokyo 155 (JP); Wongwarawipat, Wiwat, Setagaya-ku, Tokyo 155 (JP); Takatori, Sunao, Setagaya-ku, Tokyo 155 (JP); Yamamoto, Makoto, Setagaya-ku, Tokyo 155 (JP)
(74) Representative: Grünecker, Kinkeldey, Stockmair & Schwanhäusser Anwaltssozietät

(56) References cited:
- GB-A- 2 120 881
- PATENT ABSTRACTS OF JAPAN vol. 011, no. 023 (E-473)22 January 1987 & JP-A-61 193 514 (NEC CORP) 28 August 1986

## Description

### -FIELD OF THE INVENTION-

The present invention relates to a field of electric transistor of metal-oxide-semiconductor (MOS), especially to a field of electric transistor of MOS effective in integrating signal of IC.

### -BACKGROUND OF THE INVENTION-

Conventionally, it has been necessary a device comprising plural number of inputs in order to perform signal integration, and also necessary different devices as the same number of inputs.

When the same circuit is realized in IC, many libraries of the IC has been necessary. Such library is inefficient.

### -SUMMARY OF THE INVENTION-

The present invention is invented so as to solve the above problems and has an object to provide a MOSFET to easily realize the integration of plural inputs.

An electrical summation circuit according to the present invention is defined in claim 1.

### BRIEF DESCRIPTION OF THE DRAWINGS

Figure 1 shows a MOSFET circuit.

Figure 2 shows the block diagram of the structure of a circuit for signal integration using the embodiment in Figure 1.

Figure 3 shows a block diagram of the structure of a circuit for hierarchical signal integration using the embodiment in Figure 1.

"T" shows a MOSFET, dd, ddl, dd2 and ddn show input voltage, Vcc shows a power source, "D" shows a drain, "G" shows a gate, "S" shows a source, "R" shows a high resistance, "C" shows a capacitance, "DD" shows an output of a capacitance, T1, T2, Tn and To show transistors, DD, DD2 and DDn show output of transistors, DD_{COM} shows a common output, ddᵢₙ shows an input of transistor To, and ddₒᵤₜ shows and output of transistor To.

### -PREFERRED EMBODIMENT OF THE INVENTION-

An embodiment of MOSFET according to the present invention is described with reference to the attached drawings.

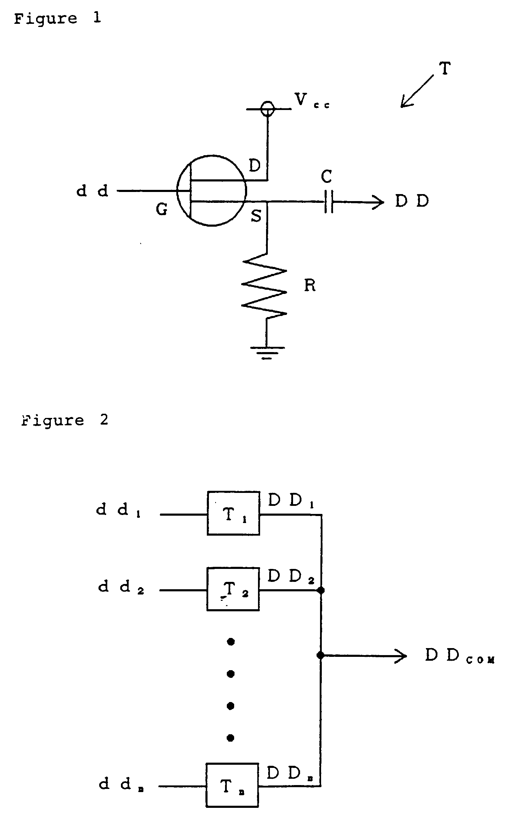

In Figure 1 with respect to MOSFET "T", gate "G" of it is connected to input voltage "dd", drain "D" is connected to power source "Vcc" and source "S" is grounded through high resistance "R". Output capacitance "C" is connected to source "S", and the output "DD" of capacitance "C" is the output of MOSFET "T".

Figure 2 shows the structure of the circuit for integrating signals. The outputs of plural number of transistors from T1 to Tn are connected to the common output (the voltage of it is "DD_{COM}). Representing the volume of output capacitance for transistors from T1 to Tn by C1 to Cn, respectively, and the volume of electricity of the capacitances by Q1 to Qn, respectively, the equations in (1) are formulated.

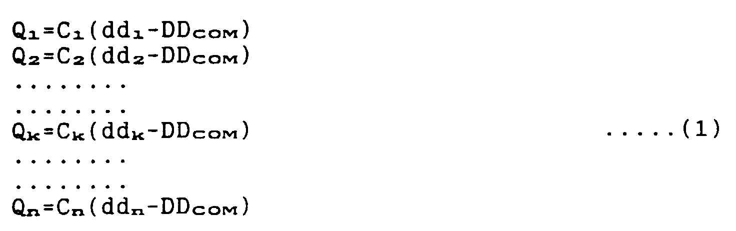

The total summations of both members are expressed as in (2).

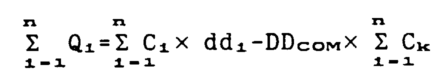

In formula (2), as Σ Cₖ and Σ Qᵢ are constants, formula (2) is varied into (3) of the equation for DD_{COM}, representing them by "Ct" and "Qt", respectively.

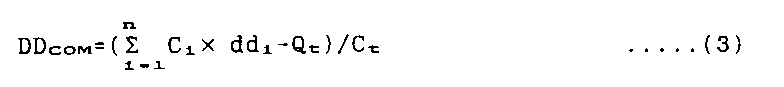

As it is clear from the formula in (3), DD_{COM} is a linear function of weighted summation (weight is "Ci") of input voltage ddᵢ. When the electrical charge of each condenser "Qi" is 0, "Qt" is also 0. In such a condition, the offset in (3) can be deleted and the formula in (4) can be obtained. 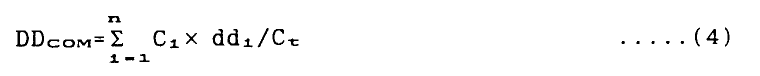 As shown, it is a simple summation of electrical change.

The signal integration can be easily realized without using plural inputs device and a circuit module.

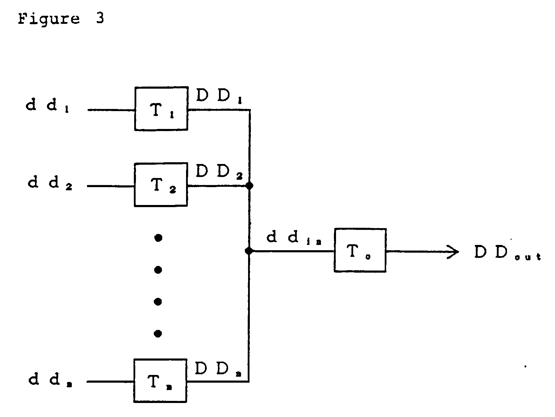

Figure 3 shows a structure for inputting such integration to the similar transistor To. The common output of transistor from T1 to Tn is connected to "ddᵢₙ" of the input of transistor To. It is possible not only to drive the transistor by the output integrated by it but also to integrate the output of to with the output of the transistor. That is, hierarchical integration of information is possible.

As mentioned, it is possible to realize easily the integration of plural inputs by the MOSFET according to the present invention because output capacitance is connected to the source.

## Claims

1. An electrical summation circuit for summing a plurality of input voltages applied at respective input voltage terminals, said circuit comprising a plurality of MOSFET-circuits,
each MOSFET-circuit including a MOSFET having a drain terminal electrically connected to a source voltage terminal, a gate terminal electrically connected to one of said input voltage terminals and a source terminal electrically connected through a high resistance to a ground terminal and electrically connected through a capacitance to an output terminal,
wherein all output terminals of said plurality of MOSFETcircuits are electrically connected together to form a combined output terminal to provide an output voltage (DD_{com}) which represents a weighted summation of the plurality of input voltages (dd₁, dd₂, ...ddₙ), and wherein the weight of each MOSFET-circuit is determined by the respective capacitance.

## Patentansprüche

1. Eine elektrische Summierschaltung zum Summieren einer Vielzahl von Eingangsspannungen, die an entsprechende Eingangsspannungsanschlüsse angelegt werden, wobei die genannte Schaltung eine Mehrzahl MOSFET-Schaltungen umfaßt,
jede MOSFET-Schaltung schließt einen MOSFET ein, der aufweist einen Drainanschluß, der elektrisch mit einem Quellenspannungsanschluß verbunden ist, einen Gateanschluß, der elektrisch mit einem der genannten Eingangsspannungsanschlüsse verbunden ist, und einen Sourceanschluß, der elektrisch über einen hohen Widerstand mit einem Masseanschluß und elektrisch über eine Kapazität mit einem Ausgangsanschluß verbunden ist,
worin alle Ausgangsanschlüsse der genannten Mehrzahl von MOSFET-Schaltungen elektrisch zusammen verbunden sind, um einen kombinierten Ausgangsanschluß zu bilden, um eine Ausgangsspannung (DD_{Com}) zu liefern, die eine gewichtete Summierung der Mehrzahl von Eingangsspannungen (dd₁, dd₂ ...ddₙ) darstellt, und worin das Gewicht von jeder MOSFET-Schaltung durch die entsprechende Kapazität bestimmt ist.

## Revendications

1. Circuit de sommation électrique pour sommer une pluralité de tensions d'entrée appliquées au niveau de bornes respectives de tension d'entrée, ledit circuit comportant une pluralité de circuits MOSFET,
chaque circuit MOSFET comportant un MOSFET ayant une borne de drain électriquement connectée à une borne de tension de source, une borne de grille électriquement connectée à l'une desdites bornes de tension d'entrée et une borne de source électriquement connectée par l'intermédiaire d'une résistance élevée à une borne de masse et électriquement connectée par l'intermédiaire d'une capacité à une borne de sortie,
dans lequel toutes les bornes de sortie de ladite pluralité de circuits MOSFET sont électriquement connectées ensemble pour former une borne de sortie combinée afin de fournir une tension de sortie (DDcom) qui représente une sommation pondérée de la pluralité de tensions d'entrée (dd₁, dd₂, ... ddₙ), et dans lequel le poids de chaque circuit MOSFET est déterminé par la capacité respective.
